# EUROPEAN PATENT APPLICATION

(11) **EP 4 503 151 A1**
(43) Date of publication of application: **05.02.2025**
(21) Application number: 22934734.9
(22) Date of filing: 30.09.2022
(51) Int. Cl.: H01L 33/38

(54) **LED CHIP AND PREPARATION METHOD THEREFOR**

(30) Priority: 30.03.2022 CN 202210327434; 30.03.2022 CN 202220719631 U
(71) Applicant: Xiamen Changelight Co., Ltd., Xiamen, Fujian 361000 (CN)
(72) Inventor: WU, Xingen, Xiamen, Fujian 361000 (CN); LIU, Yingce, Xiamen, Fujian 361000 (CN); LIU, Wei, Xiamen, Fujian 361000 (CN); WANG, Rui, Xiamen, Fujian 361000 (CN); LIN, Fengjie, Xiamen, Fujian 361000 (CN); CUI, Hengping, Xiamen, Fujian 361000 (CN); CAI, Yumei, Xiamen, Fujian 361000 (CN); CAI, Haifang, Xiamen, Fujian 361000 (CN)
(74) Representative: Michalski Hüttermann & Partner Patentanwälte mbB
(86) International application number: PCT/CN2022/123210
(87) International publication number: WO 2023/184916

(57) **Abstract**

Provided in the present invention are an LED chip and a preparation method therefor. An isolating layer of the LED chip covers an epitaxial stack and partially exposes the surface of a recess, and at least one through hole is formed in the isolating layer along the surface of a mesa; a light-emitting area is controlled by means of the through hole; in addition, the through hole is formed by performing an etching process on the isolating layer, and the isolating layer is made of an insulating material, so that the etching procedure is easy to control, thus better achieving effective control of the light-emitting area; furthermore, in the LED chip provided in the present invention, a current spreading layer directly below a current spreading metal does not make direct contact with a second-type semiconductor layer, so that currents are prevented from being collected directly below a spreading electrode, thereby improving the anti-ESD capability of the LED chip.

## Description

### CROSS-REFERENCE TO RELATED APPLICATIONS

This application claims priority to the Chinese patent application No. 202210327434.7, filed with the Patent Office of China on March 30, 2022, entitled "An LED chip and its preparation method", the entire contents of which are incorporated herein by reference.

The present application also claims priority to the Chinese patent application filed with the Chinese Patent Office on March 30, 2022, application number 202220719631.9, with the title of "an LED chip and its preparation method", the entire contents of which are incorporated herein by reference.

### TECHNICAL FIELD

The present invention relates to the field of light-emitting diodes, and in particular relates to an LED chip and its preparation method.

### BACKGROUND

With the rapid development of LED technology and the gradual improvement of LED luminous efficiency, the application of LED is more and more extensive, and people are more and more concerned about the development prospect of LED in the display screen. LED chip, as the core component of LED light, its function is to convert electrical energy into light energy, specifically, including epitaxial wafer and N-type electrode and P-type electrode respectively set on the epitaxial wafer. Said epitaxial wafer includes a P-type semiconductor layer, an N-type semiconductor layer, and an active layer located between said N-type semiconductor layer and said P-type semiconductor layer, and when there is a current passing through the LED chip, the holes in the P-type semiconductor and electrons in the N-type semiconductor will move toward the active layer and be compounded in said active layer, causing the LED chip to emit light.

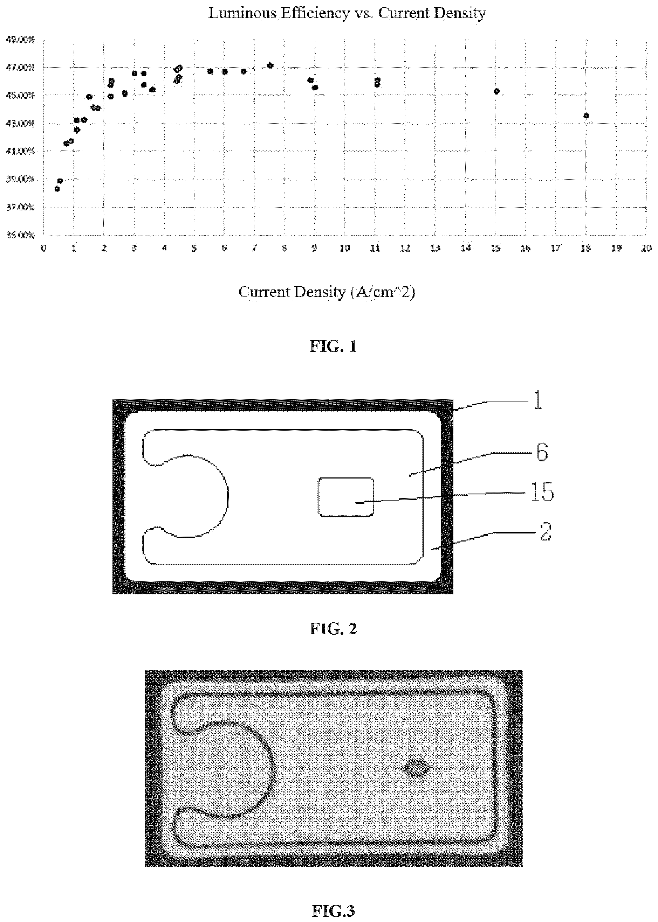

Currently the mainstream Mini LED chips on the market uses current less than 0.5mA, and some even uses current between 10 and 20µA. As the current used decreases, the luminous efficiency needs to be improved. Figure 1 lists the relationship between the luminous efficiency and current density of a 4mil*8mil size LED chip. It can be found that from the perspective of luminous efficiency and current density, the optimal luminous efficiency of an LED chip of this size is 4~6A/cm2. Assume that the current used is 20µA. Then the optimal light-emitting area is calculated to be 333µm2 to 500µm2; at the same time, as shown in Figure 2, it is usually necessary to etch the current spreading layer 6 to form the electrode hole 15 in product design; however, for small-size LEDs, due to their unit area Too small, thin, photolithography diffraction, and poor etching depth make it difficult to control the ITO area, resulting in ITO pattern abnormalities, as shown in Figure 3. In addition, as ITO is a transparent conductive layer, it is usually necessary to design a current spreading electrode to connect to the ITO surface to form a current loop. However, the reflectivity of the current spreading electrode can only reach about 70% at most, and its ability to reflect light in the luminescent area is weak; Moreover, the current accumulates directly under the current spreading electrode, and electrostatic breakdown is prone to occur.

In order to overcome the above-mentioned defects of the prior art LED chips, the inventor specially designed an LED chip and a preparation method thereof.

### CONTENTS OF THE INVENTION

The purpose of the present invention is to provide an LED chip and a preparation method thereof to achieve precise control of the light-emitting area and improve the antistatic ability of the LED chip.

In order to realize the above object, the present invention adopts the following technical solution:
An LED chip, comprises:
a substrate;
an epitaxial stack provided on the surface of the substrate, including a first type semiconductor layer, an active layer, and a second type semiconductor layer; wherein the first type semiconductor layer, the active layer, and the second type semiconductor layer are sequentially stacked in a first direction; wherein a local area of the epitaxial stack is etched to a part of the first type semiconductor layer, forming a recess and a mesa, and the first direction is perpendicular to the substrate, and points from the substrate to the epitaxial stack;
an isolating layer covering the epitaxial stack and exposes a portion of the surface of the recess to form a recess exposed portion, wherein the isolating layer along surface of the mesa has at least a through hole;
a current spreading layer stacked on a side surface of the isolating layer, wherein the side surface is located away from the mesa, and the current spreading layer is embedded in the through hole to form a contact with the epitaxial stack;
a reflective layer covering the current spreading layer and the isolating layer; wherein the reflective layer exposes the recess exposed portion and includes an electrode hole; wherein the electrode hole exposes a portion of the current spreading layer, and the center of the electrode hole is not aligned with the center of the through hole;
a first electrode stacked on the recess exposed portion extending upward to surface of the reflective layer;
a second electrode stacked on the electrode hole extending upward to the surface of the reflective layer.

Preferably, the surface area of all through holes is S, and surface area of the mesa is A, then S ≥ A/5..

Preferably, the through hole and the electrode hole do not overlap in orthogonal projection onto the mesa..

Preferably, the isolating layer along surface of the mesa has a plurality of sub-through holes and a central through hole; wherein each of the sub-through holes is uniformly distributed around the central through hole.

Preferably, the current spreading layer includes current spreading metal and the electrode hole exposes the current spreading metal to form a connection between the second electrode and the current spreading metal; wherein the current spreading metal includes one or more stacks of chromium, nickel, aluminum, titanium, platinum, gold, palladium, silver, or gold-tin alloy.

Preferably, the current spreading layer includes one or more of ITO, IZO, IGO, or ZnO.

Preferably, the reflective layer includes a DBR reflective layer.

Preferably, the isolating layer includes an insulating material.

Preferably, the first electrode and the second electrode comprise one or more stacks of chromium, nickel, aluminum, titanium, platinum, gold, palladium, silver, gold-tin alloy, respectively.

Preferably, the epitaxial stack includes at least a substrate exposed portion; wherein the isolating layer and the reflective layer are stacked on the substrate to be retained on the substrate exposed portion.

Preferably, the substrate exposed portion surrounds a perimeter of the epitaxial stack; wherein the isolating layer and the reflective layer are stacked on the substrate to be retained on the substrate exposed portion, and surround a perimeter of the epitaxial stack.

The present invention also provides a method of preparing an LED chip, the method including the following steps:
Step S01, providing a substrate;
Step S02, stacking an epitaxial stack on surface of the substrate, wherein the epitaxial stack includes a first type semiconductor layer, an active layer, and a second type semiconductor layer; wherein the first type semiconductor layer, the active layer, and the second type semiconductor layer are sequentially stacked in a first direction; wherein the first direction is perpendicular to the substrate, and points from the substrate to the epitaxial stack;
Step S03, etching a local area of the epitaxial stack to a part of the first type semiconductor layer to form a recess and a mesa;
Step S04, etching edge of the epitaxial stack to form a substrate exposed portion;
Step S05, growing an isolating layer which covers the epitaxial stack and exposes a portion of surface of the recess to form a recess exposed portion, wherein the isolating layer along surface of the mesa has at least a through hole;
Step S06, depositing a current spreading layer which is stacked on a side surface of the isolating layer, wherein the side surface is located away from the mesa, and the current spreading layer is embedded in the through hole to form a contact with the epitaxial stack;
Step S07, depositing current spreading metal on surface of current spreading layer;
Step S08, depositing a reflective layer which covers the current spreading layer and the isolating layer; wherein the reflective layer exposes the recess exposed portion and includes an electrode hole; wherein the electrode hole exposes a portion of the current spreading layer, and the center of the electrode hole is not aligned with the center of the through hole;
Step S09, making a first electrode and a second electrode, wherein the first electrode is stacked to the recess exposed portion, the second electrode is stacked to the electrode hole, and the first electrode and the second electrode are disposed away from each other.

Preferably, the surface area of all through holes is S, and surface area of the mesa is A, then S ≥ A/5.

As can be seen from the above technical solution, the LED chip includes an isolating layer, a current spreading layer, and a reflective layer. The isolating layer covers the epitaxial stack and exposes a portion of the surface of the recess to form a recess exposed portion, and the isolating layer along surface of the mesa has at least a through hole. The current spreading layer is stacked on a side surface of the isolating layer; the side surface is located away from the mesa; the current spreading layer is embedded in the through hole to form a contact with the epitaxial stack. The reflective layer covers the current spreading layer and the isolating layer; the reflective layer exposes the recess exposed portion and includes an electrode hole; the electrode hole exposes a portion of the current spreading layer, and the center of the electrode hole is not aligned with the center of the through hole. Thereby, control of the light-emitting area is realized through the through hole; at the same time, the through hole is formed by an etching process of the isolating layer, and the material of the isolating layer is insulating, so that the etching process is easy to control, so as to better realize effective control of the light-emitting area.

Further, the LED chip provided by the present invention is provided with a current spreading metal on the surface of the current spreading layer. The electrode hole exposes the current spreading metal to form a connection between the second electrode and the current spreading metal so that the current spreading layer directly below the current spreading metal does not make direct contact with the second type semiconductor layer, so that currents are prevented from being collected directly below a spreading electrode, thereby improving the anti-ESD capability of the LED chip.

It can be seen from the above technical solutions that the LED chip preparation method provided by the present invention not only achieves the beneficial effects of the above-mentioned LED chips, but also has a simple and convenient manufacturing process and is convenient for production.

### BRIEF DESCRIPTION OF THE DRAWINGS

In order to explain the embodiments of the present invention or the technical solutions in the prior art more clearly, the drawings needed to be used in the description of the embodiments or the prior art will be briefly introduced below. Obviously, the drawings in the following description are only These are embodiments of the present invention. For those of ordinary skill in the art, other drawings can be obtained based on the provided drawings without exerting creative efforts.
FIG. 1 shows a schematic diagram of the relationship between the luminous efficiency and current density of a 4 mil*8 mil size LED chip in the prior art;
FIG. 2 shows a schematic diagram of a structure of making a current spreading layer on a light-emitting mesa of an LED chip in the prior art;
FIG. 3 is a schematic diagram of the anomalies that occur during the production of the current spreading layer shown in FIG. 2;
FIG. 4 shows a schematic diagram of the structure of the LED chip provided by the embodiment of the present invention;
FIGS. 5.1 to 5.9 are schematic diagrams of the structures corresponding to the steps of the preparation method of the LED chip provided by the embodiment of the present invention;

Symbols in the figure illustrate: 1, substrate, 2, first type semiconductor layer, 3, active region, 4, second type semiconductor layer, 5, isolating layer, 6, current spreading layer, 7, reflective layer, 8, first electrode, 9, second electrode, 10, mesa, 11, recess, 12, substrate exposed portion, 13, through hole, 14, recess exposed portion, 15, electrode hole, L: current spreading metal.

### DETAILED DESCRIPTION

To make the present invention clearer, the contents of the present invention are further described below in connection with the accompanying drawings. The present invention is not limited to this specific embodiment. Based on the embodiment in the present invention, all other embodiments obtained by a person of ordinary skill in the art without making creative labor fall within the scope of protection of the present invention.

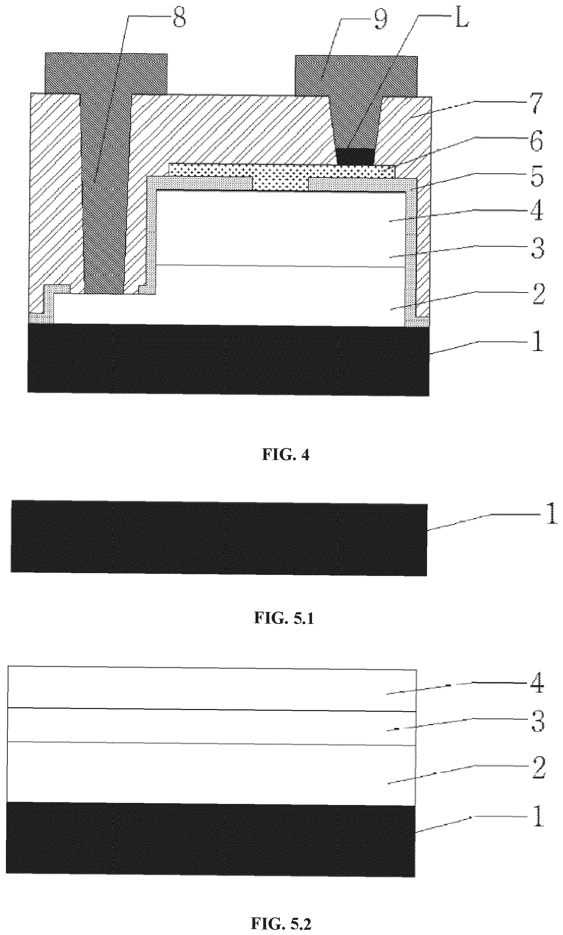

As shown in FIG. 4, an LED chip including:
a substrate 1;
an epitaxial stack provided on the surface of the substrate 1. The epitaxial stack includes at least a first type semiconductor layer 2, an active layer 3, and a second type semiconductor layer 4. The first type semiconductor layer 2, the active layer 3, and the second type semiconductor layer 4 are sequentially stacked along a first direction. A local area of the epitaxial stack is etched to a part of the first type semiconductor layer 2 to form a recess 11 and a mesa 10; the first direction is perpendicular to the substrate 1, and points from the substrate 1 to the epitaxial stack;
an isolating layer 5 covering the epitaxial stack and exposes a portion of the surface of the recess 11 to form a recess exposed portion 14, wherein the isolating layer 5 along surface of the mesa 10 has at least a through hole 13;
a current spreading layer 6 stacked on a side surface of the isolating layer 5, wherein the side surface is located away from the mesa 10, and the current spreading layer 6 is embedded in the through hole 13 to form a contact with the epitaxial stack;
a reflective layer 7 covering the current spreading layer 6 and the isolating layer 5; wherein the reflective layer 7 exposes the recess exposed portion 14 and includes an electrode hole 15; wherein the electrode hole 15 exposes a portion of the current spreading layer 6, and the center of the electrode hole is not aligned with the center of the through hole 13;
a first electrode 8 stacked on the exposed portion of the recess 11 extending upward to surface of the reflective layer 7;
a second electrode 9 stacked on the electrode hole 15 extending upward to the surface of the reflective layer 7.

Notably, the type of the substrate 1 is not limited in this embodiment of the LED chip. For example, the substrate 1 may be, but is not limited to, the sapphire substrate 1, the silicon substrate 1, and the like. Also, the types of the first type semiconductor layer 2, the active layer 3, and the second type semiconductor layer 4 of the epitaxial stack may not be limited in the LED chip of the present embodiment. For example, the first type semiconductor layer 2 may be, but is not limited to, a gallium nitride layer, and accordingly, the second type semiconductor layer 4 may be, but is not limited to, a gallium nitride layer;

Notably, the material of the isolating layer 5 may be, but is not limited to, SiO2 (silicon dioxide).

In another embodiment of the present invention, the surface area of all the through holes 13 is S, and the surface area of the mesa 10 is A. Then S ≥ A/5.

In another embodiment of the present invention, the through hole 13 and the electrode hole 15 do not overlap in orthogonal projection onto the mesa 10.

In another embodiment of the present invention, the isolating layer 5 along surface of the mesa 10 has a plurality of sub-through holes 13 and a central through hole 13; wherein each of the sub-through holes 13 is uniformly distributed around the central through hole 13.

In another embodiment of the present invention, the current spreading layer 6 include current spreading metal L and the electrode hole 15 exposes the current spreading metal L to form a connection between the second electrode 9 and the current spreading metal L; wherein the current spreading metal L includes one or more stacks of chromium, nickel, aluminum, titanium, platinum, gold, palladium, silver, or gold-tin alloy.

Similarly, in other embodiments of the present invention, further, another current spreading metal L is provided in the exposed portion of the recess 11 and the first electrode 8 is stacked on the surface of the current spreading metal L and extends upwardly to the surface of the reflective layer, which is not limited by this embodiment.

In another embodiment of the present invention, the current spreading layer 6 includes one or more of ITO, IZO, IGO, or ZnO.

In another embodiment of the present invention, the reflective layer 7 includes a DBR reflective layer 7.

In another embodiment of the present invention, the isolating layer 5 includes an insulating material.

In another embodiment of the present invention, the first electrode 8 and the second electrode 9 comprise one or more stacks of chromium, nickel, aluminum, titanium, platinum, gold, palladium, silver, or gold-tin alloys, respectively.

In another embodiment of the present invention, the epitaxial stack has at least one substrate exposed portion 12, wherein both the isolating layer 5 and the reflective layer 7 are stacked to the substrate 1 in a manner of being retained in the substrate exposed portion 12.

In another embodiment of the present invention, the substrate exposed portion 12 surrounds a perimeter of the epitaxial stack; and both the isolating layer 5 and the reflective layer 7 are stacked on the substrate 1 in such a manner as to be retained in the substrate exposed portion 12 and to surround the perimeter of the epitaxial stack.

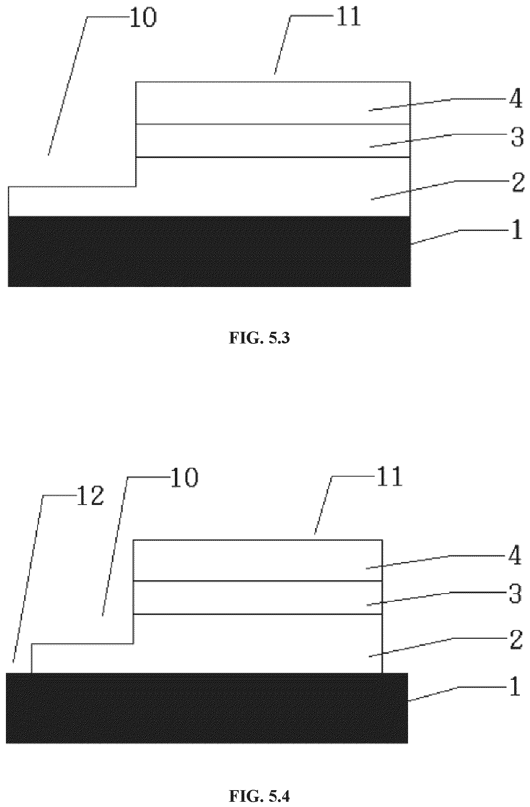

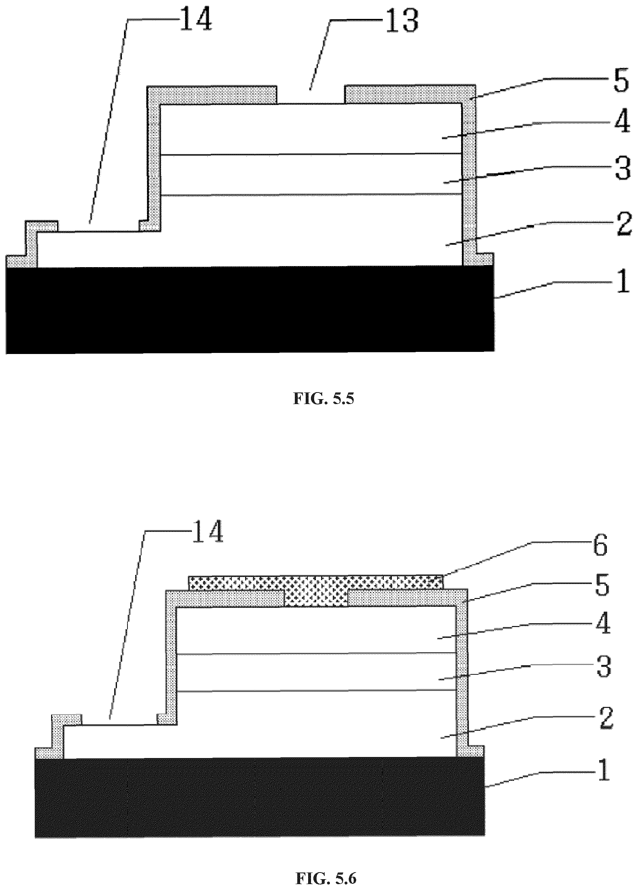

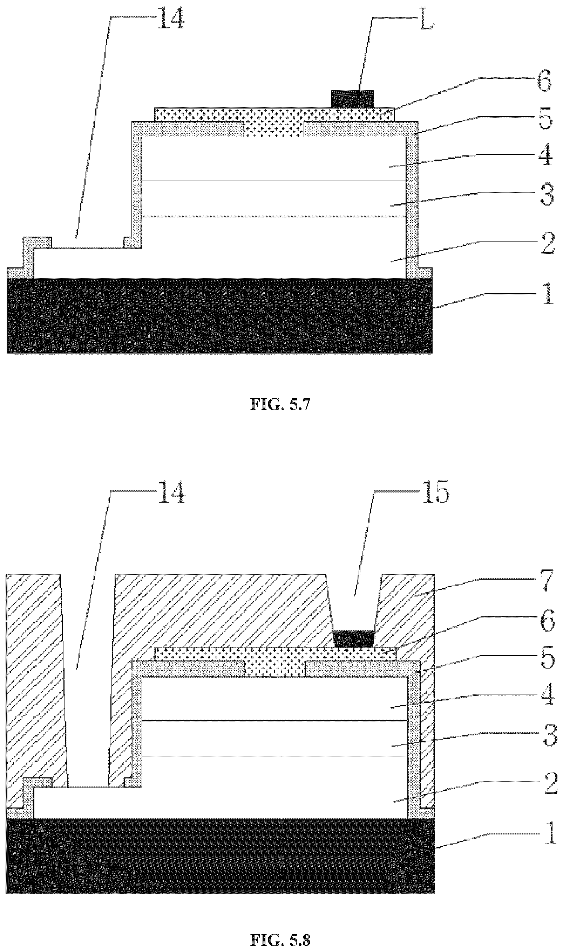

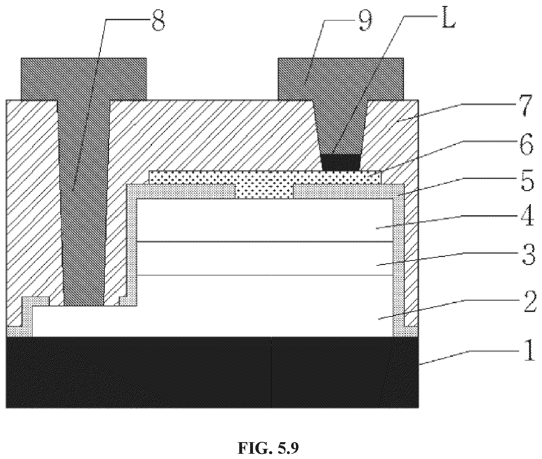

Method of preparing an LED chip is also provided, the preparation method including the following steps:
Step S01, as shown in FIG. 5.1, providing a substrate 1;
Step S02, as shown in FIG. 5.2, stacking an epitaxial stack on surface of the substrate 1, wherein the epitaxial stack comprises a first type semiconductor layer 2, an active layer 3, and a second type semiconductor layer 4. The first type semiconductor layer 2, the active layer 3, and the second type semiconductor layer 4 are sequentially stacked along a first direction. The first direction is perpendicular to the substrate 1, and points from the substrate 1 to the epitaxial stack.
Step S03, as shown in FIG. 5.3, a local area of the epitaxial stack is etched to a part of the first type semiconductor layer 2 to form a recess 11 and a mesa 10;
Step S04, as shown in FIG. 5.4, etching the edges of the epitaxial stack to form a substrate exposed portion 12;
Step S05, as shown in FIG. 5.5, growing an isolating layer 5 that covers the epitaxial stack and exposes a portion of the surface of the recess 11 to form a recess exposed portion 14, and the isolating layer 5 along the surface of the mesa 10 has at least one through hole 13;
Step S06, as shown in FIG. 5.6, depositing a current spreading layer 6, which is stacked on a side surface of the isolating layer 5 wherein the side surface is located away from the mesa 10 and embedded in the through hole 13 to form a contact with the epitaxial stack;
Step S07, as shown in FIG. 5.7, depositing a current spreading metal on the surface of the current spreading layer;
Step S08, as shown in FIG. 5.8, depositing a reflective layer 7, which covers the current spreading layer 6 and the isolating layer 5, and the reflective layer 7 exposes the recessed exposed portion 14 and has an electrode hole 15. The electrode hole 15 exposes a portion of the current spreading layer 6. The center of the electrode hole 15 is not aligned with the center of the through hole 13;
Step S09, as shown in FIG. 5.9, making a first electrode 8 and a second electrode 9. The first electrode 8 is stacked to the recess exposed portion 14, the second electrode 9 is stacked to the electrode hole 15. The first electrode 8 and the second electrode 9 are disposed away from each other.

In another embodiment of the present invention, the surface area of all the through holes 13 is S, and the surface area of the mesa 10 is A, then S ≥ A/5.

As can be seen from the above technical solution, the LED chip includes an isolating layer 5, a current spreading layer 6, and a reflective layer 7. The isolating layer 5 covers the epitaxial stack and exposes a portion of the surface of the recess 11 to form a recess exposed portion 14, and the isolating layer 5 along surface of the mesa 10 has at least a through hole 13. The current spreading layer 6 is stacked on a side surface of the isolating layer 5; the side surface is located away from the mesa 10; the current spreading layer 6 is embedded in the through hole 13 to form a contact with the epitaxial stack. The reflective layer 7 covers the current spreading layer 6 and the isolating layer 5; the reflective layer 7 exposes the recess exposed portion 14 and includes an electrode hole 15; the electrode hole exposes a portion of the current spreading layer 6, and the center of the electrode hole 15 is not aligned with the center of the through hole 13. Thereby, control of the light-emitting area is realized through the through hole 13; at the same time, the through hole 13 is formed by an etching process of the isolating layer 5, and the material of the isolating layer 5 is insulating, so that the etching process is easy to control, so as to better realize effective control of the light-emitting area.

Further, the LED chip provided by the present invention is provided with a current spreading metal on the surface of the current spreading layer. The electrode hole exposes the current spreading metal to form a connection between the second electrode and the current spreading metal so that the current spreading layer directly below the current spreading metal does not make direct contact with the second type semiconductor layer, so that currents are prevented from being collected directly below a spreading electrode, thereby improving the anti-ESD capability of the LED chip.

It can be seen from the above technical solutions that the LED chip preparation method provided by the present invention not only achieves the beneficial effects of the above-mentioned LED chips, but also has a simple and convenient manufacturing process and is convenient for production.

Each embodiment in this specification is described in a progressive manner. Each embodiment focuses on its differences from other embodiments. The same and similar parts between the various embodiments can be referred to each other.

It should also be noted that in this article, relational terms such as first and second are only used to distinguish one entity or operation from another entity or operation, and do not necessarily require or imply that these entities or operations There is no such actual relationship or sequence between them. Furthermore, the terms "comprises," "comprises," or any other variation thereof are intended to cover a non-exclusive inclusion, such that an article or device including a list of elements includes not only those elements, but also other elements not expressly listed, Or it also includes elements inherent to the article or equipment. Without further limitation, elements qualified by the statement "comprises a..." do not exclude the presence of other identical elements in articles or equipment containing the above-mentioned elements.

The above description of the disclosed embodiments enables those skilled in the art to implement or use the present application. Various modifications to these embodiments will be readily apparent to those skilled in the art, and the generic principles defined herein may be practiced in other embodiments without departing from the spirit or scope of the application. Therefore, the present application is not to be limited to the embodiments shown herein but is to be accorded the widest scope consistent with the principles and novel features disclosed herein.

## Claims

1. An LED chip, comprising:
a substrate;
an epitaxial stack provided on the surface of the substrate, comprising a first type semiconductor layer, an active layer, and a second type semiconductor layer; wherein the first type semiconductor layer, the active layer, and the second type semiconductor layer are sequentially stacked in a first direction; wherein a local area of the epitaxial stack is etched to a part of the first type semiconductor layer, forming a recess and a mesa, and the first direction is perpendicular to the substrate, and points from the substrate to the epitaxial stack;
an isolating layer covering the epitaxial stack and exposes a portion of the surface of the recess to form a recess exposed portion, wherein the isolating layer along surface of the mesa has at least a through hole;
a current spreading layer stacked on a side surface of the isolating layer, wherein the side surface is located away from the mesa, and the current spreading layer is embedded in the through hole to form a contact with the epitaxial stack;
a reflective layer covering the current spreading layer and the isolating layer; wherein the reflective layer exposes the recess exposed portion and comprises an electrode hole; wherein the electrode hole exposes a portion of the current spreading layer, and the center of the electrode hole is not aligned with the center of the through hole;
a first electrode stacked on the recess exposed portion extending upward to surface of the reflective layer;
a second electrode stacked on the electrode hole extending upward to the surface of the reflective layer.

2. The LED chip according to claim 1, wherein surface area of all through holes is S, and surface area of the mesa is A, then S ≥ A/5.

3. The LED chip according to claim 1, wherein the through hole and the electrode hole do not overlap in orthogonal projection onto the mesa.

4. The LED chip according to claim 1, wherein the isolating layer along surface of the mesa has a plurality of sub-through holes and a central through hole; wherein each of the sub-through holes is uniformly distributed around the central through hole.

5. The LED chip according to claim 1, wherein the current spreading layer comprises current spreading metal and the electrode hole exposes the current spreading metal to form a connection between the second electrode and the current spreading metal; wherein the current spreading metal comprises one or more stacks of chromium, nickel, aluminum, titanium, platinum, gold, palladium, silver, or gold-tin alloy.

6. The LED chip according to claim 1, wherein the current spreading layer comprises one or more of ITO, IZO, IGO, or ZnO.

7. The LED chip according to claim 1, wherein the reflective layer comprises a DBR reflective layer.

8. The LED chip according to claim 1, wherein the first electrode and the second electrode respectively comprise one or more stacks of chromium, nickel, aluminum, titanium, platinum, gold, palladium, silver, or gold-tin alloy.

9. The LED chip according to claim 1, wherein the epitaxial stack comprises at least a substrate exposed portion; wherein the isolating layer and the reflective layer are stacked on the substrate to be retained on the substrate exposed portion.

10. The LED chip according to claim 9, wherein the substrate exposed portion surrounds a perimeter of the epitaxial stack; wherein the isolating layer and the reflective layer are stacked on the substrate to be retained on the substrate exposed portion, and surround a perimeter of the epitaxial stack.

11. A LED chip preparation method comprising:
Step S01, providing a substrate;
Step S02, stacking an epitaxial stack on surface of the substrate, wherein the epitaxial stack comprises a first type semiconductor layer, an active layer, and a second type semiconductor layer; wherein the first type semiconductor layer, the active layer, and the second type semiconductor layer are sequentially stacked in a first direction; wherein the first direction is perpendicular to the substrate, and points from the substrate to the epitaxial stack;
Step S03, etching a local area of the epitaxial stack to a part of the first type semiconductor layer to form a recess and a mesa;
Step S04, etching edge of the epitaxial stack to form a substrate exposed portion;
Step S05, growing an isolating layer which covers the epitaxial stack and exposes a portion of surface of the recess to form a recess exposed portion, wherein the isolating layer along surface of the mesa has at least a through hole;
Step S06, depositing a current spreading layer which is stacked on a side surface of the isolating layer, wherein the side surface is located away from the mesa, and the current spreading layer is embedded in the through hole to form a contact with the epitaxial stack;
Step S07, depositing current spreading metal on surface of current spreading layer;
Step S08, depositing a reflective layer which covers the current spreading layer and the isolating layer; wherein the reflective layer exposes the recess exposed portion and comprises an electrode hole; wherein the electrode hole exposes a portion of the current spreading layer, and the center of the electrode hole is not aligned with the center of the through hole;
Step S09, making a first electrode and a second electrode, wherein the first electrode is stacked to the recess exposed portion, the second electrode is stacked to the electrode hole, and the first electrode and the second electrode are disposed away from each other.

12. The LED chip preparation method according to claim 11, wherein surface area of all through holes is S, and surface area of the mesa is A, then S ≥ A/5.
